(19) **Europäisches Patentamt European Patent Office Office européen des brevets**

(11) **EP 4 586 436 B1**

(12) **EUROPEAN PATENT SPECIFICATION**

(45) Date of publication and mention of the grant of the patent:
**01.07.2026 Bulletin 2026/27**

(21) Application number: **24223721.2**

(22) Date of filing: **30.12.2024**

(51) International Patent Classification (IPC):
*H02J 103/30* $^{(2026.01)}$    *H02J 103/35* $^{(2026.01)}$
*H02J 3/18* $^{(2026.01)}$    *G01R 19/25* $^{(2006.01)}$
*G01R 31/08* $^{(2020.01)}$

(52) Cooperative Patent Classification (CPC):
**H02J 3/18; G01R 19/2513; G01R 31/086;**
H02J 2103/30; H02J 2103/35

(54) **METHOD AND SYSTEM FOR ESTIMATING LINE PARAMETERS AND STATES OF ELECTRICAL DISTRIBUTION NETWORK**

VERFAHREN UND SYSTEM ZUR SCHÄTZUNG VON LEITUNGSPARAMETERN UND ZUSTÄNDEN EINES ELEKTRISCHEN VERTEILUNGSNETZWERKS

PROCÉDÉ ET SYSTÈME D'ESTIMATION DE PARAMÈTRES ET D'ÉTATS DE LIGNE D'UN RÉSEAU DE DISTRIBUTION ÉLECTRIQUE

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **10.01.2024 IN 202421001995**

(43) Date of publication of application:
**16.07.2025 Bulletin 2025/29**

(73) Proprietor: **Tata Consultancy Services Limited Maharashtra (IN)**

(72) Inventors:
• **ROY CHOWDHURY, NILANJAN**
  **411057 Pune - Maharashtra (IN)**
• **RAO, ANUJ KUMAR**
  **411057 Pune - Maharashtra (IN)**
• **NAGARATHINAM, SRINARAYANA**
  **600113 Chennai, Tamil Nadu (IN)**
• **VELAYUDHAN KUMAR, MOHAN RAJ**
  **600113 Chennai, Tamil Nadu (IN)**
• **VARGHESE, ALBYN ALEX**
  **400601 Thane - Maharashtra (IN)**
• **BICHPURIYA, YOGESH KUMAR**
  **411057 Pune - Maharashtra (IN)**
• **SARANGAN, VENKATESH**
  **600113 Chennai, Tamil Nadu (IN)**
• **RAJAGOPAL, NARAYANAN**
  **560009 Bangalore - Karnataka (IN)**

(74) Representative: **Goddar, Heinz J.**
**Boehmert & Boehmert**
**Anwaltspartnerschaft mbB**
**Pettenkoferstrasse 22**
**80336 München (DE)**

(56) References cited:
**US-A1- 2012 078 436    US-A1- 2023 085 739**

• **KONG XIANGHAO ET AL: "Dynamic Parameter Estimation with Physics-based Neural Ordinary Differential Equations", 2022 IEEE POWER & ENERGY SOCIETY GENERAL MEETING (PESGM), IEEE, 17 July 2022 (2022-07-17), pages 1 - 5, XP034215683, DOI: 10.1109/ PESGM48719.2022.9916840**
• **CUOMO SALVATORE ET AL: "Scientific Machine Learning Through Physics-Informed Neural Networks: Where we are and What's Next", JOURNAL OF SCIENTIFIC COMPUTING, SPRINGER US, NEW YORK, vol. 92, no. 3, 26 July 2022 (2022-07-26), XP037917814, ISSN: 0885-7474, [retrieved on 20220726], DOI: 10.1007/ S10915-022-01939-Z**

**Description**

CROSS-REFERENCE TO RELATED APPLICATIONS AND PRIORITY

The present application claims priority to Indian application no. 202421001995, filed on January 10, 2024.

TECHNICAL FIELD

The disclosure herein generally relates to distribution network management, and, more particularly, to a method and a system for estimating line parameters and state of an electrical distribution grid/network.

BACKGROUND

In power systems, accurate estimation of state and parameters plays a crucial role in performing informed decision-making for network management. Generally, electrical network state estimation is performed using a weighted least square method which uses redundant measurements for determining network states. However, practical inaccuracies associated with the redundant measurements leads to inaccurate estimation of network states and parameters.

Currently, Phasor Measurement Units are commonly used in transmission systems for state and parameter estimation. However, the level of instrumentation i.e., the number of measurement devices present in distribution systems is way less and different than that required for using the Phasor Measurement Units. In several real-world distribution networks, the redundant measurements may not even exist, hence making the use of Phasor Measurement Units nearly impossible due to insufficient observability.

Further, the distribution system line parameters can become uncertain due to various factors, such as vegetation growth, aging, and similar influences which further adds to the measurement complexity as the available systems, such as Gauss-Newton solver are sensitive to initial point.

Additionally, the traditionally available joint estimation algorithms that jointly estimate line parameters and state estimation often suffer from computational complexity i.e. they usually have high computational requirement and scalability issues.

Document US 2012/078436 discloses a processor implemented method, comprising:receiving, by a system via one or more hardware processors, a plurality of inputs associated with a distribution network and a time period details from a user device, wherein the plurality of inputs comprises a real time bus power injection data and a historical voltage data, wherein the real time bus power injection data comprises an active power injection data and a reactive power injection data;initializing, by the system via the one or more hardware processors, one or more model parameters of a neural network, wherein the one or more model parameters and the drift matrix are initialized randomly;iteratively performing:estimating, by the system via the one or more hardware processors, one or more bus voltages based, at least in part, on the plurality of inputs, the time period details, the one or more initialized model parameters, and the initialized drift matrix by applying a forward pass technique on the neural network, wherein the one or more bus voltages comprises a bus voltage, an initial bus voltage and an observed bus voltage;computing, by the system via the one or more hardware processors, a loss function for the neural network based, at least in part, on the bus voltage, the initial bus voltage, the observed bus voltage and the derivative of the estimated bus voltage using a loss function computation technique;computing, by the system via the one or more hardware processors, a gradient of the loss function with respect to the one or more initialized model parameters using a backward pass technique;identifying, by the system via the one or more hardware processors, an optimal value of each of the one or more model parameters that minimizes the loss function using a stochastic optimization technique;estimating, by the system via the one or more hardware processors, a line current, a line active power flow and a line reactive power flow based, at least in part, on the estimated line resistance, the estimated line reactance and the final bus voltage using one or more predefined analytical power flow equations.

SUMMARY

Embodiments of the present disclosure present technological improvements as solutions to one or more of the above-mentioned technical problems recognized by the inventors in conventional systems. For example, in one aspect, there is provided a method for estimating line parameters and state of an electrical distribution network. The method comprises receiving, by a system via one or more hardware processors, a plurality of inputs associated with a distribution network and a time period details from a user device, wherein the plurality of inputs comprises a real time bus power injection data and a historical voltage data, wherein the real time bus power injection data comprises an active power injection data and a reactive power injection data; initializing, by the system via the one or more hardware processors, one or more model parameters of a neural network and a drift matrix of the distribution network, wherein the one or more model parameters and the drift matrix are initialized randomly; iteratively performing: estimating, by the system via the one or more hardware processors, one or more bus voltages based, at least in part, on the plurality of inputs, the time period details, the one or more initialized model parameters, and the initialized drift matrix by applying a forward pass technique on the neural network, wherein the one or more bus voltages comprises a bus voltage, an initial bus voltage and an observed bus voltage; computing, by the system via the one or more hardware processors, a derivative of the estimated bus voltage based on the time period details using an automatic differentiation technique; computing, by the system via the one or more hardware processors, a loss function for the neural network based, at least in part, on the bus voltage, the initial bus voltage, the observed bus voltage and the derivative of the estimated bus voltage using a loss function computation technique; computing, by the system via the one or more hardware processors, a gradient of the loss function with respect to the one or more initialized model parameters and the initialized drift matrix using a backward pass technique; identifying, by the system via the one or more hardware processors, an optimal value of each of the one or more model parameters and the drift matrix that minimizes the loss function using a stochastic optimization technique; determining, by the system via the one or more hardware processors, whether the optimal value of the drift matrix is meeting a predefined drift matrix criteria; and upon determining that the optimal value of the drift matrix is not meeting the predefined drift matrix criteria, updating, by the system via the one or more hardware processors, the optimal value of the drift matrix as the initialized drift matrix and the optimal value of each model parameters as the initialized model parameter, until the initialized drift matrix meets the predefined drift matrix criteria; identifying, by the system via the one or more hardware processors, the initialized drift matrix as an optimal drift matrix and the bus voltage as a final bus voltage; estimating, by the system via the one or more hardware processors, a line resistance and a line reactance of the distribution network based on the optimal drift matrix by solving a predefined non-linear least square error minimization problem; and estimating, by the system via the one or more hardware processors, a line current, a line active power flow and a line reactive power flow based, at least in part, on the estimated line resistance, the estimated line reactance and the final bus voltage using one or more predefined analytical power flow equations.

In an embodiment, the method comprises: displaying, by the system via the one or more hardware processors, the line resistance, the line reactance, the line current, the final bus voltage, the line active power flow and the line reactive power flow on the user device.

In an embodiment, wherein the loss function is a combination of a physical loss, an initial value loss and a labeled data loss.

In an embodiment, the physical loss is computed by performing: computing, by the system via the one or more hardware processors, a residual based on the derivative of the estimated bus voltage using a predefined residual calculation equation; and computing, by the system via the one or more hardware processors, a Euclidean norm of the residual to obtain the physical loss.

In an embodiment, the initial value loss is calculated by computing the Euclidean norm of the residual calculated, based on the initial bus voltage, and wherein the labeled data loss is calculated by computing the Euclidean norm of the residual calculated, based on the observed bus voltage.

In another aspect, there is provided a system for estimating line parameters and state of an electrical distribution network. The system comprises a memory storing instructions; one or more communication interfaces; and one or more hardware processors coupled to the memory via the one or more communication interfaces, wherein the one or more hardware processors are configured by the instructions to: receive a plurality of inputs associated with a distribution network and a time period details from a user device, wherein the plurality of inputs comprises a real time bus power injection data and a historical voltage data, wherein the real time bus power injection data comprises an active power injection data and a reactive power injection data; initialize one or more model parameters of a neural network and a drift matrix of the distribution network, wherein the one or more model parameters and the drift matrix are initialized randomly; iteratively perform: estimate one or more bus voltages based, at least in part, on the plurality of inputs, the time period details, the one or more initialized model parameters, and the initialized drift matrix by applying a forward pass technique on the neural network, wherein the one or more bus voltages comprises a bus voltage, an initial bus voltage and an observed bus voltage; compute a derivative of the estimated bus voltage based on the time period details using an automatic differentiation technique; compute a loss function for the neural network based, at least in part, on the bus voltage, the initial bus voltage, the observed bus voltage and the derivative of the estimated bus voltage using a loss function computation technique; compute a gradient of the loss function with respect to the one or more initialized model parameters and the initialized drift matrix using a backward pass technique; identify an optimal value of each of the one or more model parameters and the drift matrix that minimizes the loss function using a stochastic optimization technique; determine whether the optimal value of the drift matrix is meeting a predefined drift matrix criteria; and upon determining that the optimal value of the drift matrix is not meeting the predefined drift matrix criteria, update the optimal value of the drift matrix as the initialized drift matrix and the optimal value of each model parameters as the initialized model parameter, until the initialized drift matrix meets the predefined drift matrix criteria; identify the initialized drift matrix as an optimal drift matrix and the bus voltage as a final bus voltage; estimate a line resistance and a line reactance of the distribution network based on the optimal drift matrix by solving a predefined non-linear least square error minimization problem; and estimate a line current, a line active power flow and a line reactive power flow based, at least in part, on the estimated line resistance, the estimated line reactance and the final bus voltage using one or more predefined analytical power flow equations.

In yet another aspect, there are provided one or more non-transitory machine-readable information storage mediums comprising one or more instructions which when executed by one or more hardware processors estimate line parameters and state of an electrical distribution network by receiving, by a system via one or more hardware processors, a plurality of inputs associated with a distribution network and a time period details from a user device, wherein the plurality of inputs comprises a real time bus power injection data and a historical voltage data, wherein the real time bus power injection data comprises an active power injection data and a reactive power injection data; initializing, by the system via the one or more hardware processors, one or more model parameters of a neural network and a drift matrix of the distribution network, wherein the one or more model parameters and the drift matrix are initialized randomly; iteratively performing: estimating, by the system via the one or more hardware processors, one or more bus voltages based, at least in part, on the plurality of inputs, the time period details, the one or more initialized model parameters, and the initialized drift matrix by applying a forward pass technique on the neural network, wherein the one or more bus voltages comprises a bus voltage, an initial bus voltage and an observed bus voltage; computing, by the system via the one or more hardware processors, a derivative of the estimated bus voltage based on the time period details using an automatic differentiation technique; computing, by the system via the one or more hardware processors, a loss function for the neural network based, at least in part, on the bus voltage, the initial bus voltage, the observed bus voltage and the derivative of the estimated bus voltage using a loss function computation technique; computing, by the system via the one or more hardware processors, a gradient of the loss function with respect to the one or more initialized model parameters and the initialized drift matrix using a backward pass technique; identifying, by the system via the one or more hardware processors, an optimal value of each of the one or more model parameters and the drift matrix that minimizes the loss function using a stochastic optimization technique; determining, by the system via the one or more hardware processors, whether the optimal value of the drift matrix is meeting a predefined drift matrix criteria; and upon determining that the optimal value of the drift matrix is not meeting the predefined drift matrix criteria, updating, by the system via the one or more hardware processors, the optimal value of the drift matrix as the initialized drift matrix and the optimal value of each model parameters as the initialized model parameter, until the initialized drift matrix meets the predefined drift matrix criteria; identifying, by the system via the one or more hardware processors, the initialized drift matrix as an optimal drift matrix and the bus voltage as a final bus voltage; estimating, by the system via the one or more hardware processors, a line resistance and a line reactance of the distribution network based on the optimal drift matrix by solving a predefined non-linear least square error minimization problem; and estimating, by the system via the one or more hardware processors, a line current, a line active power flow and a line reactive power flow based, at least in part, on the estimated line resistance, the estimated line reactance and the final bus voltage using one or more predefined analytical power flow equations.

It is to be understood that both the foregoing general description and the following detailed description are exemplary and explanatory only and are not restrictive of the invention, as claimed.

## BRIEF DESCRIPTION OF THE DRAWINGS

The accompanying drawings, which are incorporated in and constitute a part of this disclosure, illustrate exemplary embodiments and, together with the description, serve to explain the disclosed principles:

FIG. 1 is an example representation of an environment, related to at least some example embodiments of the present disclosure.

FIG. 2 illustrates an exemplary block diagram of a system for estimating line parameters and state of an electrical distribution network, in accordance with an embodiment of the present disclosure.

FIG. 3 illustrates a schematic representation of an estimation process performed by the system of FIG. 2 for estimating line parameters and network states of the electrical distribution network, in accordance with an embodiment of the present disclosure.

FIGS. 4A, 4B and 4C, collectively, illustrate an exemplary flow diagram of a method for estimating line parameters and state of the electrical distribution network, in accordance with an embodiment of the present disclosure.

FIG. 5 illustrates an exemplary representation of an iterative process followed by the system of FIG. 2 for obtaining optimal value of drift matrix and model parameters, in accordance with an embodiment of the present disclosure.

## DETAILED DESCRIPTION OF EMBODIMENTS

Exemplary embodiments are described with reference to the accompanying drawings. In the figures, the left-most digit(s) of a reference number identifies the figure in which the reference number first appears. Wherever convenient, the same reference numbers are used throughout the drawings to refer to the same or like parts. While examples and features of disclosed principles are described herein, modifications, adaptations, and other implementations are possible without departing from the scope of the disclosed embodiments.

Insufficient instrumentation and uncertainty in line parameters hinder distribution network operations, particularly voltage regulation. So, joint estimation of state and parameters is required for efficient distribution network management. In particular, accurate real-time monitoring of distribution networks is pivotal to ensure reliable and optimal operation of the grid/network.

Several algorithms that are available for jointly estimating power system states and line parameters fall into two major categories. The first category is based on residual sensitivity analysis, which separates state and parameter estimation into distinct stages while preserving core state estimation. The second category uses the state vector augmentation method that concurrently estimates states and parameters. However, both the categories rely on computationally intensive iterative least square techniques which makes them suffer from computational complexity.

Other existing machine-learning based estimation techniques, which jointly estimate the state and parameter, solely focus on the transmission systems, and these techniques cannot be blindly invoked in distribution networks as input data for distribution systems is very different from what required for transmission systems.

So, a joint estimation technique that can jointly estimate line parameters and state of electrical distribution network while reducing the computational complexity is still to be explored.

Embodiments of the present disclosure overcome the above-mentioned disadvantages by providing a method and a system for estimating line parameters and state of an electrical distribution grid/network. The system of the present disclosure first uses lossy Distflow equations and an inverse Physics-Informed Neural Network (iPINN) architecture for learning network voltage dynamics, drift matrix and network bus voltages from real-time bus power injection data and historical voltage data. Thereafter, the system determines a plurality of line parameters from the learnt drift matrix using a least-square optimization technique. Finally, the system calculates line power flows and line currents using the lossy Distflow equations.

In the present disclosure, the system and the method use the lossy Distflow equations for learning network voltage dynamics and for calculating line power flows and line currents, thus ensuring accurate capturing of behavior of the distribution network which further ensures accurate estimation of the line and state parameters. Further, the lossy Distflow equations are less computationally intensive, thereby reducing the computational load requirement of the system. The system estimates the network voltages and line flows without knowing the exact values of the line parameters, thereby eliminating the dependence on the initial values.

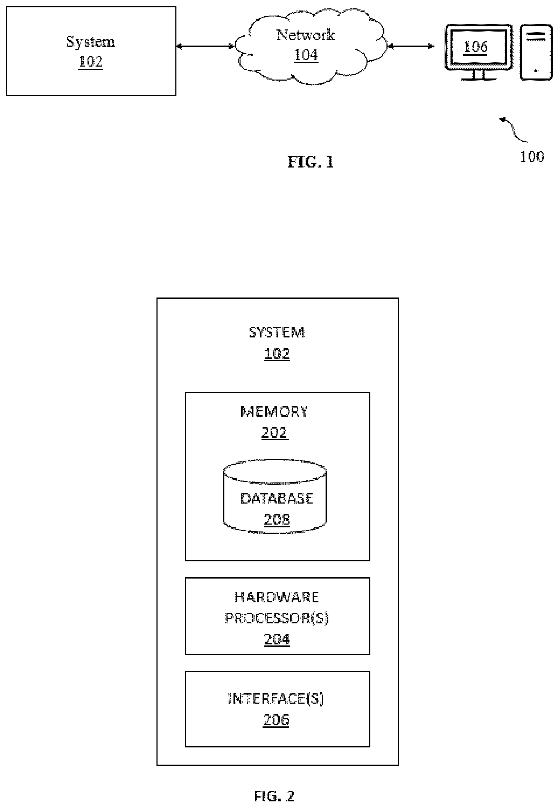

Referring now to the drawings, and more particularly to FIGS. 1 through 5, where similar reference characters denote corresponding features consistently throughout the figures, there are shown preferred embodiments and these embodiments are described in the context of the following exemplary system and/or method.

FIG. 1 illustrates an exemplary representation of an environment 100 related to at least some example embodiments of the present disclosure. Although the environment 100 is presented in one arrangement, other embodiments may include the parts of the environment 100 (or other parts) arranged otherwise depending on, for example, estimating bus voltages, computing loss function, identifying optimal values of a drift matrix, etc. The environment 100 generally includes a system 102, an electronic device 106 (hereinafter also referred as a user device 106), each coupled to, and in communication with (and/or with access to) a network 104. It should be noted that one user device is shown for the sake of explanation; there can be more number of user devices.

The network 104 may include, without limitation, a light fidelity (Li-Fi) network, a local area network (LAN), a wide area network (WAN), a metropolitan area network (MAN), a satellite network, the Internet, a fiber optic network, a coaxial cable network, an infrared (IR) network, a radio frequency (RF) network, a virtual network, and/or another suitable public and/or private network capable of supporting communication among two or more of the parts or users illustrated in FIG. 1, or any combination thereof.

Various entities in the environment 100 may connect to the network 104 in accordance with various wired and wireless communication protocols, such as Transmission Control Protocol and Internet Protocol (TCP/IP), User Datagram Protocol (UDP), 2nd Generation (2G), 3rd Generation (3G), 4th Generation (4G), 5th Generation (5G) communication protocols, Long Term Evolution (LTE) communication protocols, or any combination thereof.

The user device 106 is associated with a user (e.g., a network operator/control center operator) who is responsible for managing electricity distribution network. Examples of the user device 106 include, but are not limited to, a personal computer (PC), a mobile phone, a tablet device, a Personal Digital Assistant (PDA), a server, a voice activated assistant, a smartphone, and a laptop.

The system 102 includes one or more hardware processors and a memory. The system 102 is first configured to receive a plurality of inputs associated with a distribution network and a time period details via the network 104 from the user device 106. The plurality of inputs includes a real time bus power injection data and a historical pseudo measurements of bus voltage magnitudes (herein after also referred as historical voltage data).

Then, the system 102 estimates a network drift matrix and one or more bus voltages based on the plurality of inputs using an inverse Physics-Informed Neural Network (iPINN) framework. It should be noted that the iPINN framework utilized by the system 102 is a trained neural network.

Thereafter, the system 102 uses a least square optimization technique to determine estimates for line resistance and line reactance (also referred as line parameters) based on the drift matrix. Further, the system 102 estimates the line power flows and line currents (also referred as network states) using lossy Distflow equations. It should be noted that the lossy Distflow equations are obtained by first modeling a radial distribution network considering mild technical assumptions which generally hold in real world scenarios and then, based on these assumptions, non-linear power flow equations of the radial distribution network are approximated to obtain its equivalent lossy Distflow equations.

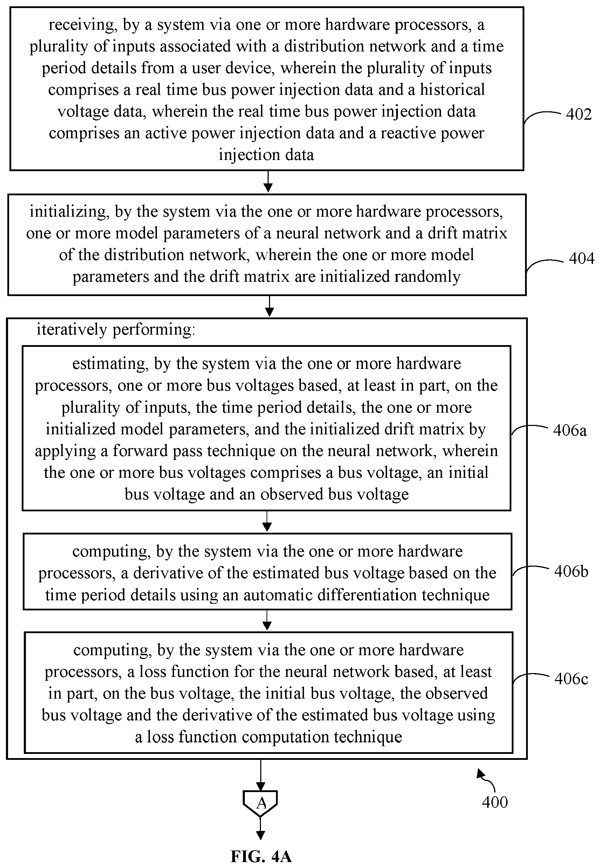

The process of estimating line parameters and network states is explained in detail with reference to FIGS. 4A-4C.

The number and arrangement of systems, devices, and/or networks shown in FIG. 1 are provided as an example. There may be additional systems, devices, and/or networks; fewer systems, devices, and/or networks; different systems, devices, and/or networks; and/or differently arranged systems, devices, and/or networks than those shown in FIG. 1. Furthermore, two or more systems or devices shown in FIG. 1 may be implemented within a single system or device, or a single system or device shown in FIG. 1 may be implemented as multiple, distributed systems or devices. Additionally, or alternatively, a set of systems (e.g., one or more systems) or a set of devices (e.g., one or more devices) of the environment 100 may perform one or more functions described as being performed by another set of systems or another set of devices of the environment 100 (e.g., refer scenarios described above).

FIG. 2 illustrates an exemplary block diagram of the system 102 for estimating line parameters and state of an electrical distribution network, in accordance with an embodiment of the present disclosure. In some embodiments, the system 102 is embodied as a cloud-based and/or SaaS-based (software as a service) architecture. In some embodiments, the system 102 may be implemented in a server system. In some embodiments, the system 102 may be implemented in a variety of computing systems, such as laptop computers, notebooks, hand-held devices, workstations, mainframe computers, and the like.

In an embodiment, the system 102 includes one or more processors 204, communication interface device(s) or input/output (I/O) interface(s) 206, and one or more data storage devices or memory 202 operatively coupled to the one or more processors 204. The one or more processors 204 may be one or more software processing modules and/or hardware processors. In an embodiment, the hardware processors can be implemented as one or more microprocessors, microcomputers, microcontrollers, digital signal processors, central processing units, state machines, logic circuitries, and/or any devices that manipulate signals based on operational instructions. Among other capabilities, the processor(s) is configured to fetch and execute computer-readable instructions stored in the memory. In an embodiment, the system 102 can be implemented in a variety of computing systems, such as laptop computers, notebooks, hand-held devices, workstations, mainframe computers, servers, a network cloud and the like.

The I/O interface device(s) 206 can include a variety of software and hardware interfaces, for example, a web interface, a graphical user interface, and the like and can facilitate multiple communications within a wide variety of networks N/W and protocol types, including wired networks, for example, LAN, cable, etc., and wireless networks, such as WLAN, cellular, or satellite. In an embodiment, the I/O interface device(s) can include one or more ports for connecting a number of devices to one another or to another server.

The memory 202 may include any computer-readable medium known in the art including, for example, volatile memory, such as static random access memory (SRAM) and dynamic random access memory (DRAM), and/or non-volatile memory, such as read only memory (ROM), erasable programmable ROM, flash memories, hard disks, optical disks, and magnetic tapes. In an embodiment a database 208 can be stored in the memory 202, wherein the database 208 may comprise, but are not limited to, a predefined drift matrix criteria, a drift matrix, an automatic differentiation technique, a loss function computation technique, a stochastic optimization technique, a non-linear least square error minimization problem, one or more analytical power flow equations, one or more processes and the like. The memory 202 further comprises (or may further comprise) information pertaining to input(s)/output(s) of each step performed by the systems and methods of the present disclosure. In other words, input(s) fed at each step and output(s) generated at each step are comprised in the memory 202 and can be utilized in further processing and analysis.

It is noted that the system 102 as illustrated and hereinafter described is merely illustrative of an apparatus that could benefit from embodiments of the present disclosure and, therefore, should not be taken to limit the scope of the present disclosure. It is noted that the system 102 may include fewer or more components than those depicted in FIG. 2.

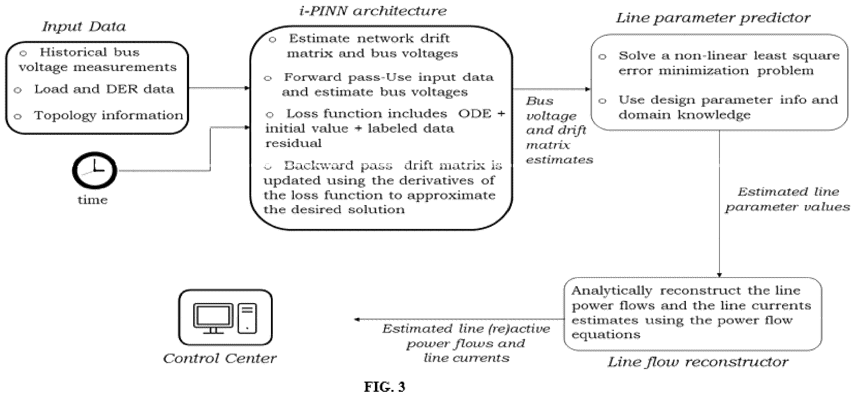

FIG. 3 illustrates a schematic block diagram representation of an estimation process performed by the system 102 for estimating line parameters and network states of the electrical distribution network, in accordance with an embodiment of the present disclosure.

As seen in FIG. 3, the system 102 first receives a plurality of inputs, such as the historical bus voltage measurements/data, the real time bus power injection data, such as the load and distributed energy resources (DER) data, and time period details. The system 102 then passes the plurality of inputs to the iPINN framework/architecture which utilizes the received information for estimating network drift matrix and one or more bus voltages. In an embodiment, the iPINN framework first utilizes a forward-pass technique to estimate the bus voltages based on the plurality of inputs. Thereafter, the iPINN framework computes a loss function for the neural network based on the one or more bus voltages using a loss function computation technique. The loss function includes Ordinary Differential Equations (ODE) residuals, initial value residuals, and labelled data residuals. The process of computing the loss function is explained in detail with reference to FIG. 4A-4C. Further, the iPINN framework utlizes a Backword-pass technique to update the drift matrix using derivative of the loss function.

In an embodiment, the system 102 then passes the bus voltages and the drift matrix estimates to a line parameter predictor that estimates line parameters i.e., a line resistance and a line reactance of the distribution network by solving a predefined non-linear least square error minimization problem based on the drift matrix and domain knowledge.

Finally, the system 102 passes the estimated line parameters to line flow reconstructor that estimates line currents, and line power flows i.e., a line active power flow and a line reactive power flow based on the estimated line resistance, the estimated line reactance and the bus voltages using one or more predefined analytical power flow equations. The estimated line parameters and network states are then shared with the user through the user device 106.

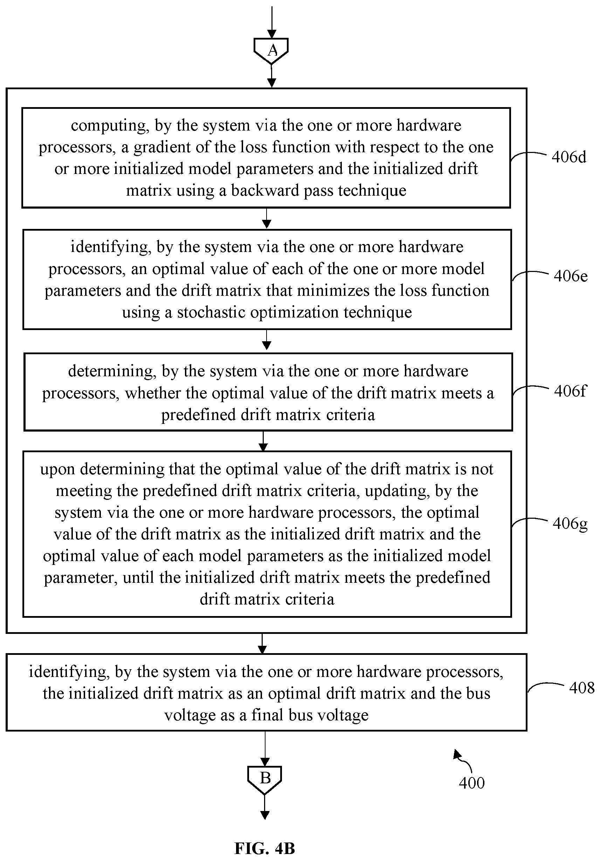

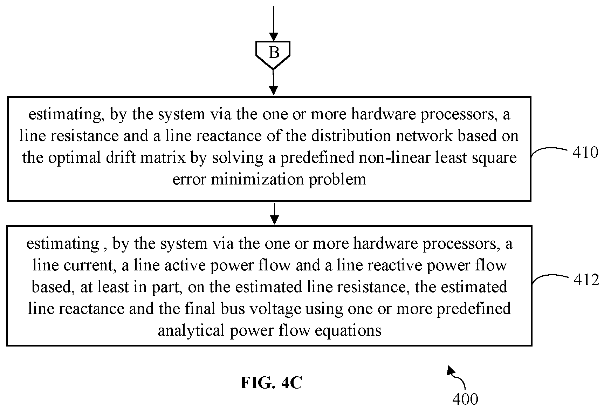

FIGS. 4A, 4B and 4C, collectively, with reference to FIGS. 1 to 3, represent an exemplary flow diagram of a method 400 for estimating line parameters and state of the electrical distribution network, in accordance with an embodiment of the present disclosure. The method 400 may use the system 102 of FIGS. 1 and 2 for execution. In an embodiment, the system 102 comprises one or more data storage devices or the memory 208 operatively coupled to the one or more hardware processors 206 and is configured to store instructions for execution of steps of the method 400 by the one or more hardware processors 206. The sequence of steps of the flow diagram may not be necessarily executed in the same order as they are presented. Further, one or more steps may be grouped together and performed in form of a single step, or one step may have several sub-steps that may be performed in parallel or in sequential manner. The steps of the method of the present disclosure will now be explained with reference to the components of the system 102 as depicted in FIG. 2 and FIG. 1.

At step 402 of the present disclosure, the one or more hardware processors 206 of the system 102 receive a plurality of inputs associated with a distribution network and a time period details t from a user device. The plurality of inputs comprises a real time bus power injection data and a historical voltage data. The real time bus power injection data comprises an active power injection data and a reactive power injection data. It should be noted that the distribution network considered here is a balanced and radial electrical distribution network and it includes $N + 1$ nodes and $N$ edges. The radial electrical distribution network, in general, can be modelled as a tree graph. The root node of the graph is considered as the slack bus, and a voltage $v_0$ of the slack bus is known and fixed.

At step 404 of the present disclosure, the one or more hardware processors 206 of the system 102 initialize one or more model parameters $\theta$ of a neural network and a drift matrix $\hat{\mathcal{F}}$ of the distribution network. The one or more model parameters and the drift matrix are initialized randomly. It should be noted that the neural network is a trained network and is also referred as the iPINN network/architecture.

In an embodiment, for training the neural network, first the key hyperparameters of the neural network are defined by subject matter experts (SMEs). Examples of the key hyperparameters include, but are not limited to, a learning rate of the neural network, number of iterations, a time slot length and a number of training example samples. In at least one example embodiment, the training examples comprises one or more of collocation examples, initial value examples and observed data losses examples. Thereafter, few samples are selected (referred as sample spaces) from each of the collocation examples, the initial value examples and the observed data losses examples. The selected sample spaces are denoted as $N_p$, $N_0$ and $N_d$ denoting collocation samples, initial value samples and observed data loss samples, respectively. The sample spaces are then used to train the neural network i.e. the iPINN neural network.

At step 406 of the present disclosure, the one or more hardware processors 206 of the system 102 computes an optimal value of the drift matrix and the optimal value of each model parameter of the one or more model parameter by iteratively performing a plurality of steps 406a through 406g until the initialized drift matrix meets a predefined drift matrix criteria.

More specifically, at step 406a of the present disclosure, the one or more hardware processors 204 of the system 102 estimate one or more bus voltages based, at least in part, on the plurality of inputs, the time period details, the one or more initialized model parameters and the initialized drift matrix by applying a forward pass technique on the neural network. The one or more bus voltages includes a bus voltage, an initial bus voltage and an observed bus voltage.

In an embodiment, in forward pass technique, the sample spaces generated by the collocation examples, initial value examples and the observed data losses examples are used to estimate the bus voltage $\hat{v}_p(t)$, the initial bus voltage $\hat{v}^0(t)$ and the observed voltage $\hat{v}_d(t)$, respectively.

At step 406b of the present disclosure, the one or more hardware processors 206 of the system 102 compute derivative of the estimated bus voltage based on the time period details using an automatic differentiation technique. In particular, the derivative of the estimated bus voltage $\hat{v}_p(t)$ is computed with respect to time period $t$, i.e., $\frac{\partial}{\partial t} \hat{v}_p(t)$ is obtained at step 406b.

At step 406c of the present disclosure, the one or more hardware processors 206 of the system 102 compute a loss function for the neural network based, at least in part, on the bus voltage, the initial bus voltage, the observed bus voltage and the derivative of the estimated bus voltage using a loss function computation technique.

In an embodiment, the loss function includes three losses i.e., a physics loss, an initial value loss and a labeled data loss. The physics loss $\mathcal{L}_{phy}$ is a sum of the mean squared ordinary differential equation (ODE) residuals. In at least one example embodiment, the ODE residual $\mathcal{R}_p$ is computed considering the difference between the left-hand and right-hand sides of a differential equation mentioned below:

$$\frac{d}{dt}\hat{v}(t) = \mathcal{F}(\varrho, \hat{r}, \hat{x})u(t) + d(t) \qquad \ldots \text{equation (1)},$$

Where, $\mathcal{F}(\varrho, \hat{r}, \hat{x})$ is an initialized estimated drift matrix,

$u(t)$ is rate of change of reactive power injection,
$d(t)$ is rate of change active power injection.

  a. So,

$$\mathcal{R}_p = \frac{\partial}{\partial t}\hat{v}_p(t) - \mathcal{F}(\varrho, \hat{r}, \hat{x})u(t) - d(t) \ \ldots \text{equation (2)}$$

Based on the above equation, the physics loss $\mathcal{L}_{phy}$ is computed as

$$\mathcal{L}_{phy} = \frac{1}{N_p}\sum_{N_p}\left\|\mathcal{R}_p\right\|^2$$

Where, $\|\mathcal{R}_p\|$ computes a standard Euclidean norm of the residual $\mathcal{R}_p$ and $N_p$ denotes the collocation samples.

In particular, for computing the physical loss $\mathcal{L}_{phy}$, the system 102 first computes a residual $\mathcal{R}_p$ based on the derivative $\frac{d}{dt}\hat{v}(t)$ of the estimated bus voltage using a predefined residual calculation equation defined in equation (2). Thereafter, the system 102 computes a Euclidean norm of the residual to obtain the physical loss.

Similarly, the initial value loss $\mathcal{L}_{init}$ and the labeled data loss $\mathcal{L}_{data}$ are calculated as:

$$\mathcal{L}_{init} = \frac{1}{N_0}\sum_{N_0}\|\hat{v}^0 - v^0\|^2, \qquad \mathcal{L}_{data} = \frac{1}{N_d}\sum_{N_d}\|\hat{v}_d - v_d\|^2$$

Where, $\|.\|$ computes the Euclidian norm of mentioned quantity.

In particular, the initial value loss $\mathcal{L}_{init}$ is calculated by computing the Euclidean norm of the residual calculated based on the initial bus voltage $\hat{v}^0$ and the labeled data loss $\mathcal{L}_{data}$ is calculated by computing the Euclidean norm of the residual calculated based on the observed bus voltage $\hat{v}_d$.

So, considering above definitions of $\mathcal{L}_{phy}$, $\mathcal{L}_{init}$ and $\mathcal{L}_{data}$, the total loss function is denoted as:

$$\mathcal{L}(\theta, \mathcal{F}) = \mathcal{L}_{phy} + \mathcal{L}_{init} + \mathcal{L}_{data}$$

At step 406d of the present disclosure, the one or more hardware processors 206 of the system 102 computes a gradient of the loss function with respect to the one or more initialized model parameters and the initialized drift matrix using a backward pass technique.

In particular, the gradients of the loss function $\mathcal{L}(\theta, \mathcal{F})$ is computed with respect to the initialized neural network

model parameters $\theta$ and the distribution network drift matrix $\hat{\mathcal{F}}$ at this step.

At step 406e of the present disclosure, the one or more hardware processors 206 of the system 102 identify an optimal value of each of the one or more model parameters and the drift matrix that minimizes the loss function using a stochastic optimization technique. In an embodiment, without limiting the scope of the invention, the stochastic optimization technique is a Quasi-newton method. The optimal $\theta$ and $\hat{\mathcal{F}}$ that minimize the loss function are determined at this step.

At step 406f of the present disclosure, the one or more hardware processors 206 of the system 102 determine whether the optimal value of the drift matrix meets a predefined drift matrix criteria. In at least one example embodiment, the predefined drift matrix criteria depend on the rate of change of the loss function. If

the rate of change of loss function is below a pre-defined value, the system 102 considers the optimal value is meeting the predefined drift matrix criteria else not.

At step 406g of the present disclosure, the one or more hardware processors 206 of the system 102 update the optimal value of the drift matrix as the initialized drift matrix and the optimal value of each model parameter as the initialized model parameter upon determining that the optimal value of the drift matrix is not meeting the predefined drift matrix criteria.

So, to obtain the optimal value of the drift matrix and each model parameter, the system keep on performing the steps 406a to 406g until the initialized drift matrix meets the predefined drift matrix criteria.

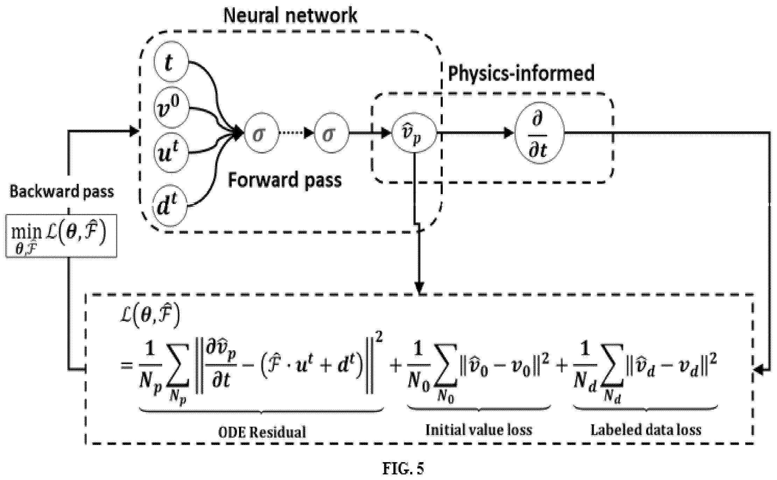

This iterative process performed by the system 102 ensures that the optimal value is obtained for each of the drift matrix and model parameters. In an embodiment, the steps 406a to 406g are performed for EPOCHS, which is a very large, predefined number selected by domain experts. An exemplary representation of an iterative process followed by the system 102 for obtaining the optimal value of the drift matrix and each model parameter is shown with reference to FIG. 5.

In an embodiment, an algorithm used for obtaining the optimal value of the drift matrix and each model parameter is defined below:

1. Define Hyperparameters: $\alpha$, EPOCHS

2. Inputs: $N_p$, $N_0$, $N_d$, $\tau$

3. Draw Samples:

    a. $X_p \leftarrow sample[(t,u,d,v^0),N_p]$
    b. $X_0 \leftarrow sample\ [(0,\ u,\ d,\ v^0),\ N_0],\ v^0 \leftarrow X_0$
    c. $X_d \leftarrow sample[(\tau,\ u,\ d,\ v^0),N_0],\ v_d \leftarrow X_d$

4. Randomly initialize model parameter $\theta$ and the drift matrix $\mathcal{F}$ of the model $\mathcal{M}$

5. *For ic* = 1 to EPOCHS do

    a. $\hat{v}_p \leftarrow$ *Evaluate* $\mathcal{M}(X_p)$

    b. $\hat{v}_0 \leftarrow$ *Evaluate* $\mathcal{M}(X_0)$

    c. $\hat{v}_d \leftarrow$ *Evaluate* $\mathcal{M}(X_d)$

    d. $\dfrac{d\hat{v}_p}{dt} \leftarrow$ *Autodif f*$(\hat{v}_p)$

    e. Obtain residuals $\mathcal{R}_p$ using line 5a and 5c as

$$\mathcal{R}_p = \frac{\partial}{\partial t}\hat{v}_p(t) - \mathcal{F}(\varrho, \hat{r}, \hat{x})u(t) - d(t)$$

    f. Compute loss function $\mathcal{L}(\theta, \mathcal{F})$ as

$$\mathcal{L}(\theta, \mathcal{F}) = \mathcal{L}_{phy} + \mathcal{L}_{init} + \mathcal{L}_{data}$$

where

$$\mathcal{L}_{phy} = \frac{1}{N_p} \sum_{N_p} \left\| \mathcal{R}_p \right\|^2$$

$$\mathcal{L}_{init} = \frac{1}{N_0} \sum_{N_0} \left\| \hat{v}^0 - v^0 \right\|^2$$

$$\mathcal{L}_{data} = \frac{1}{N_d} \sum_{N_d} \left\| \hat{v}_d - v_d \right\|^2$$

g. Evaluate gradients $\nabla_\theta \mathcal{L}(\theta, \mathcal{F})$ and $\nabla_\mathcal{F} \mathcal{L}(\theta, \mathcal{F})$

h. Minimize loss function based on L-BFGS Optimizer $min_{\theta, \mathcal{F}} \mathcal{L}_{(\theta, \mathcal{F})}$

6. Return $\mathcal{M}(\theta, \mathcal{F})$

At step 408 of the present disclosure, the one or more hardware processors 206 of the system 102 identify the initialized drift matrix as an optimal drift matrix and the bus voltage as a final bus voltage.

At step 410 of the present disclosure, the one or more hardware processors 206 of the system 102 estimate a line resistance and a line reactance of the distribution network based on the optimal drift matrix by solving a predefined non-linear least square error minimization problem.

In particular, the optimal value of the network drift matrix $\hat{\mathcal{F}}$ goes as input to solve the predefined non-linear least square error minimization problem to obtain the estimates of the line resistance and the line reactance of the given electrical distribution network. The error minimization problem is defined as:

$$\min_{r,x} \sum_{i,j} (\hat{\mathcal{F}}_{ij} - \mathcal{F}_{ij})^2$$

$$subject\ to\ r_{ij} > 0, x_{ij} > 0$$

$$using\ domain\ knowledge\ constrain\ \frac{r_{ij}}{x_{ij}}$$

Here, the drift matrix $\mathcal{F}(\varrho, \hat{r}, \hat{x})$ is defined as:

$$\hat{\mathcal{F}}(\varrho, \hat{r}, \hat{x}) = 2\mathcal{B}^{-1}(I + \hat{\Phi}\hat{\Psi})^{-1} D(\hat{x})(\mathcal{B}^T)^{-1},$$

Where,

$$\hat{\Psi} = D(\hat{r}^2 + \hat{x}^2)^{-1}(I - 2D(\varrho))$$

$$\hat{\Phi} = D(\hat{r}^2 + \hat{x}^2) + 2D(r)(\mathcal{B}^T)^{-1}D(r) + 2D(x)(\mathcal{B}^T)^{-1}D(x)$$

and

$$\mathcal{F} = 2\mathcal{B}^{-1}(I + \Phi\Psi)^{-1}D(x)(\mathcal{B}^T)^{-1}$$

$$\Psi = D(r^2 + x^2)^{-1}\big(I - 2D(\varrho)\big)$$

$$\Phi = D(r^2 + x^2) + 2D(r)(\mathcal{B}^T)^{-1}D(r) + 2D(x)(\mathcal{B}^T)^{-1}D(x)$$

The matrices $D(\hat{r})$ and $D(\hat{x})$ are diagonal in nature, where each diagonal entries contain estimated line resistance and line reactance, i.e.

$$D(\hat{r}) = \begin{bmatrix} \hat{r}_1 & 0 & 0 & 0 \\ 0 & \hat{r}_2 & 0 & 0 \\ 0 & 0 & \ddots & 0 \\ 0 & 0 & 0 & \hat{r}_N \end{bmatrix}$$

$$D(\hat{x}) = \begin{bmatrix} \hat{x}_1 & 0 & 0 & 0 \\ 0 & \hat{x}_2 & 0 & 0 \\ 0 & 0 & \ddots & 0 \\ 0 & 0 & 0 & \hat{x}_N \end{bmatrix}$$

At step 412 of the present disclosure, the one or more hardware processors 206 of the system 102 estimate a line current, a line active power flow and a line reactive power flow based, at least in part, on the estimated line resistance, the estimated line reactance and the final bus voltage using one or more predefined analytical power flow equations. In particular, the line current, and the line active and reactive power flows are reconstructed at this step for the electrical distribution network. The reconstructions of the line current and the line active and reactive power flows are performed employing the analytical power flow equations defined below:

$$\hat{l}(t) = D(\hat{r}^2 + \hat{x}^2)^{-1}\big(I - 2D(\varrho)\big)\mathcal{B}(\hat{v}(t) - v_0 1_n)\ldots\text{equation (3)},$$

$$p(t) = \mathcal{B}^T\hat{P}(t) + D(\hat{r})\hat{l}(t)\ldots\text{equation (4)},$$

$$q(t) = \mathcal{B}^T\hat{Q}(t) + D(\hat{x})\hat{l}(t)\ \ldots\text{equation (5)},$$

Where, $\hat{l}(t)$ denotes line current,
$p(t)$ denotes line active power flow, and
$q(t)$ denotes line reactive power flow.

In an embodiment, the system 102 displays the line resistance, the line reactance, the line current, the final bus voltage, the line active power flow and the line reactive power flow on the user device 106.

The written description describes the subject matter herein to enable any person skilled in the art to make and use the embodiments. The scope of the subject matter embodiments is defined by the claims and may include other modifications that occur to those skilled in the art. Such other modifications are intended to be within the scope of the claims if they have similar elements that do not differ from the literal language of the claims or if they include equivalent elements with insubstantial differences from the literal language of the claims.

As discussed earlier, existing joint parameter-state estimation techniques struggle to provide fast estimation due to scalability issues. Further, they are sensitive to initial values. So, to overcome the disadvantages, embodiments of the present disclosure provide a method and a system for estimating line parameters and state of an electrical distribution network. More specifically, the system and the method uses the lossy Distflow equations for learning network voltage dynamics and for calculating line power flows and line currents, thus ensuring accurate capturing of behavior of the distribution network. Further, the lossy Distflow equations are less computationally intensive which reduces the computational load requirement of the system. The system estimates the network voltages and line flows without knowing the exact values of the line parameters, thereby eliminating the dependence on the initial values.

It is to be understood that the scope of the protection is extended to such a program and in addition to a computer-readable means having a message therein; such computer-readable storage means contain program-code means for implementation of one or more steps of the method, when the program runs on a server or mobile device or any suitable programmable device. The hardware device can be any kind of device which can be programmed including e.g., any kind of computer like a server or a personal computer, or the like, or any combination thereof. The device may also include means which could be e.g., hardware means like e.g., an application-specific integrated circuit (ASIC), a field-programmable gate array (FPGA), or a combination of hardware and software means, e.g., an ASIC and an FPGA, or at least one microprocessor and at least one memory with software processing components located therein. Thus, the means can include both hardware means, and software means. The method embodiments described herein could be implemented in hardware and software. The device may also include software means. Alternatively, the embodiments may be implemented on different hardware devices, e.g., using a plurality of CPUs.

The embodiments herein can comprise hardware and software elements. The embodiments that are implemented in software include but are not limited to, firmware, resident software, microcode, etc. The functions performed by various components described herein may be implemented in other components or combinations of other components. For the purposes of this description, a computer-usable or computer readable medium can be any apparatus that can comprise, store, communicate, propagate, or transport the program for use by or in connection with the instruction execution system, apparatus, or device.

The illustrated steps are set out to explain the exemplary embodiments shown, and it should be anticipated that ongoing technological development will change the manner in which particular functions are performed. These examples are presented herein for purposes of illustration, and not limitation. Further, the boundaries of the functional building blocks have been arbitrarily defined herein for the convenience of the description. Alternative boundaries can be defined so long as the specified functions and relationships thereof are appropriately performed. Alternatives (including equivalents, extensions, variations, deviations, etc., of those described herein) will be apparent to persons skilled in the relevant art(s) based on the teachings contained herein. Such alternatives fall within the scope of the disclosed embodiments. Also, the words "comprising," "having," "containing," and "including," and other similar forms are intended to be equivalent in meaning and be open ended in that an item or items following any one of these words is not meant to be an exhaustive listing of such item or items, or meant to be limited to only the listed item or items. It must also be noted that as used herein and in the appended claims, the singular forms "a," "an," and "the" include plural references unless the context clearly dictates otherwise.

Furthermore, one or more computer-readable storage media may be utilized in implementing embodiments consistent with the present disclosure. A computer-readable storage medium refers to any type of physical memory on which information or data readable by a processor may be stored. Thus, a computer-readable storage medium may store instructions for execution by one or more processors, including instructions for causing the processor(s) to perform steps or stages consistent with the embodiments described herein. The term "computer-readable medium" should be understood to include tangible items and exclude carrier waves and transient signals, i.e., be non-transitory. Examples include random access memory (RAM), read-only memory (ROM), volatile memory, nonvolatile memory, hard drives, CD ROMs, DVDs, flash drives, disks, and any other known physical storage media.

It is intended that the disclosure and examples be considered as exemplary only, with a true scope of disclosed embodiments being indicated by the following claims.

**Claims**

**1.** A processor implemented method (400), comprising:

receiving (402), by a system via one or more hardware processors, a plurality of inputs associated with a distribution network and a time period details from a user device, wherein the plurality of inputs comprises a real time bus power injection data and a historical voltage data, wherein the real time bus power injection data comprises an active power injection data and a reactive power injection data;

initializing (404), by the system via the one or more hardware processors, one or more model parameters of a neural network and a drift matrix of the distribution network, wherein the one or more model parameters and the drift matrix are initialized randomly;

iteratively performing (406):

estimating (406a), by the system via the one or more hardware processors, one or more bus voltages based, at least in part, on the plurality of inputs, the time period details, the one or more initialized model parameters, and the initialized drift matrix by applying a forward pass technique on the neural network, wherein the one or more bus voltages comprises a bus voltage, an initial bus voltage and an observed bus voltage;

computing (406b), by the system via the one or more hardware processors, a derivative of the estimated bus voltage based on the time period details using an automatic differentiation technique;

computing (406c), by the system via the one or more hardware processors, a loss function for the neural network based, at least in part, on the bus voltage, the initial bus voltage, the observed bus voltage and the derivative of the estimated bus voltage using a loss function computation technique;

computing (406d), by the system via the one or more hardware processors, a gradient of the loss function with respect to the one or more initialized model parameters and the initialized drift matrix using a backward pass technique;

identifying (406e), by the system via the one or more hardware processors, an optimal value of each of the one or more model parameters and the drift matrix that minimizes the loss function using a stochastic optimization technique;

determining (406f), by the system via the one or more hardware processors, whether the optimal value of the drift matrix meets a predefined drift matrix criteria; and

upon determining that the optimal value of the drift matrix is not meeting the predefined drift matrix criteria, updating (406g), by the system via the one or more hardware processors, the optimal value of the drift matrix as the initialized drift matrix and the optimal value of each model parameters as the initialized model parameter,

until the initialized drift matrix meets the predefined drift matrix criteria;

identifying (408), by the system via the one or more hardware processors, the initialized drift matrix as an optimal drift matrix and the bus voltage as a final bus voltage;

estimating (410), by the system via the one or more hardware processors, a line resistance and a line reactance of the distribution network based on the optimal drift matrix by solving a predefined non-linear least square error minimization problem; and

estimating (412), by the system via the one or more hardware processors, a line current, a line active power flow and a line reactive power flow based, at least in part, on the estimated line resistance, the estimated line reactance and the final bus voltage using one or more predefined analytical power flow equations.

2. The processor implemented method (400) as claimed in claim 1, comprising:
displaying, by the system via the one or more hardware processors, the line resistance, the line reactance, the line current, the final bus voltage, the line active power flow and the line reactive power flow on the user device.

3. The processor implemented method (400) as claimed in claim 1, wherein the loss function is a combination of a physical loss, an initial value loss and a labeled data loss.

4. The processor implemented method (400) as claimed in claim 3, wherein the physical loss is computed by:

computing, by the system via the one or more hardware processors, a residual based on the derivative of the estimated bus voltage using a predefined residual calculation equation; and
computing, by the system via the one or more hardware processors, a Euclidean norm of the residual to obtain the physical loss.

5. The processor implemented method (400) as claimed in claim 4, wherein the initial value loss is calculated by computing the Euclidean norm of the residual, calculated based on the initial bus voltage, and wherein the labeled data loss is calculated by computing the Euclidean norm of the residual, calculated based on the observed bus voltage.

6. A system (102), comprising:

a memory (202) storing instructions;
one or more communication interfaces (206); and
one or more hardware processors (204) coupled to the memory (202) via the one or more communication interfaces (206), wherein the one or more hardware processors (204) are configured by the instructions to:

receive a plurality of inputs associated with a distribution network and a time period details from a user device, wherein the plurality of inputs comprises a real time bus power injection data and a historical voltage data, wherein the real time bus power injection data comprises an active power injection data and a reactive power injection data;

initialize one or more model parameters of a neural network and a drift matrix of the distribution network, wherein the one or more model parameters and the drift matrix are initialized randomly;

iteratively perform:

estimate one or more bus voltages based, at least in part, on the plurality of inputs, the time period details, the one or more initialized model parameters, and the initialized drift matrix by applying a forward pass technique on the neural network, wherein the one or more bus voltages comprises a bus voltage, an initial bus voltage and an observed bus voltage;

compute a derivative of the estimated bus voltage based on the time period details using an automatic differentiation technique;

compute a loss function for the neural network based, at least in part, on the bus voltage, the initial bus voltage, the observed bus voltage and the derivative of the estimated bus voltage using a loss function computation technique;

compute a gradient of the loss function with respect to the one or more initialized model parameters and the initialized drift matrix using a backward pass technique;

identify an optimal value of each of the one or more model parameters and the drift matrix that minimizes the loss function using a stochastic optimization technique;

determine whether the optimal value of the drift matrix is meeting a predefined drift matrix criteria; and upon determining that the optimal value of the drift matrix is not meeting the predefined drift matrix criteria, update the optimal value of the drift matrix as the initialized drift matrix and the optimal value of each model parameters as the initialized model parameter,

until the initialized drift matrix meets the predefined drift matrix criteria;

identify the initialized drift matrix as an optimal drift matrix and the bus voltage as a final bus voltage;

estimate a line resistance and a line reactance of the distribution network based on the optimal drift matrix by solving a predefined non-linear least square error minimization problem; and

estimate a line current, a line active power flow and a line reactive power flow based, at least in part, on the estimated line resistance, the estimated line reactance and the final bus voltage using one or more predefined analytical power flow equations.

7. The system (102) of claim 6, wherein the one or more hardware processors (204) are configured by the instructions to: display the line resistance, the line reactance, the line current, the final bus voltage, the line active power flow and the line reactive power flow on the user device.

8. The system (102) of claim 6, wherein the loss function is a combination of a physical loss, an initial value loss and a labeled data loss.

9. The system (102) of claim 6, wherein the one or more hardware processors (204) compute the physical loss by:

compute a residual based on the derivative of the estimated bus voltage using a predefined residual calculation equation; and

compute a Euclidean norm of the residual to obtain the physical loss.

10. The system (102) of claim 9, wherein the initial value loss is calculated by computing the Euclidean norm of the residual, calculated based on the initial bus voltage, and wherein the labeled data loss is calculated by computing the Euclidean norm of the residual, calculated based on the observed bus voltage.

11. One or more non-transitory machine-readable information storage mediums comprising one or more instructions which when executed by one or more hardware processors cause:

receiving, a plurality of inputs associated with a distribution network and a time period details from a user device, wherein the plurality of inputs comprises a real time bus power injection data and a historical voltage data, wherein the real time bus power injection data comprises an active power injection data and a reactive power injection data;

initializing, one or more model parameters of a neural network and a drift matrix of the distribution network, wherein the one or more model parameters and the drift matrix are initialized randomly;
iteratively performing:

estimating, one or more bus voltages based, at least in part, on the plurality of inputs, the time period details, the one or more initialized model parameters, and the initialized drift matrix by applying a forward pass technique on the neural network, wherein the one or more bus voltages comprises a bus voltage, an initial bus voltage and an observed bus voltage;

computing, a derivative of the estimated bus voltage based on the time period details using an automatic differentiation technique;

computing, a loss function for the neural network based, at least in part, on the bus voltage, the initial bus voltage, the observed bus voltage and the derivative of the estimated bus voltage using a loss function computation technique;

computing, a gradient of the loss function with respect to the one or more initialized model parameters and the initialized drift matrix using a backward pass technique;

identifying, an optimal value of each of the one or more model parameters and the drift matrix that minimizes the loss function using a stochastic optimization technique;

determining, whether the optimal value of the drift matrix meets a predefined drift matrix criteria; and

upon determining that the optimal value of the drift matrix is not meeting the predefined drift matrix criteria, updating, the optimal value of the drift matrix as the initialized drift matrix and the optimal value of each model parameters as the initialized model parameter,

until the initialized drift matrix meets the predefined drift matrix criteria;

identifying, the initialized drift matrix as an optimal drift matrix and the bus voltage as a final bus voltage;

estimating, a line resistance and a line reactance of the distribution network based on the optimal drift matrix by solving a predefined non-linear least square error minimization problem; and

estimating, a line current, a line active power flow and a line reactive power flow based, at least in part, on the estimated line resistance, the estimated line reactance and the final bus voltage using one or more predefined analytical power flow equations.

12. The one or more non-transitory machine-readable information storage mediums of claim 11, comprising:
displaying, the line resistance, the line reactance, the line current, the final bus voltage, the line active power flow and the line reactive power flow on the user device.

13. The one or more non-transitory machine-readable information storage mediums of claim 11, wherein the loss function is a combination of a physical loss, an initial value loss and a labeled data loss.

14. The one or more non-transitory machine-readable information storage mediums of claim 13, wherein the physical loss is computed by:

computing, a residual based on the derivative of the estimated bus voltage using a predefined residual calculation equation; and
computing, a Euclidean norm of the residual to obtain the physical loss.

15. The one or more non-transitory machine-readable information storage mediums of claim 14, wherein the initial value loss is calculated by computing the Euclidean norm of the residual, calculated based on the initial bus voltage, and wherein the labeled data loss is calculated by computing the Euclidean norm of the residual, calculated based on the observed bus voltage.

**Patentansprüche**

1. Prozessorimplementiertes Verfahren (400), umfassend:

Empfangen (402), durch ein System über einen oder mehrere Hardwareprozessoren, einer Mehrzahl von Eingaben, die mit einem Verteilungsnetzwerk assoziiert sind, und von Zeitperiodendetails von einer Benutzervorrichtung, wobei die Mehrzahl von Eingaben Echtzeit-Busleistungsinjektionsdaten und historische Spannungsdaten umfasst, wobei die Echtzeit-Busleistungsinjektionsdaten Wirkleistungsinjektionsdaten und Blindleistungsinjektionsdaten umfassen;

Initialisieren (404), durch das System über den einen oder die mehreren Hardwareprozessoren, eines oder mehrerer Modellparameter eines neuronalen Netzwerks und einer Driftmatrix des Verteilungsnetzwerks, wobei der eine oder die mehreren Modellparameter und die Driftmatrix zufällig initialisiert werden;

iteratives Durchführen (406):

Schätzen (406a), durch das System über den einen oder die mehreren Hardwareprozessoren, einer oder mehrerer Busspannungen basierend, zumindest teilweise, auf der Mehrzahl von Eingaben, den Zeitperiodendetails, dem einen oder den mehreren initialisierten Modellparametern und der initialisierten Driftmatrix durch Anwenden einer Vorwärtsdurchgangstechnik auf das neuronale Netzwerk, wobei die eine oder die mehreren Busspannungen eine Busspannung, eine anfängliche Busspannung und eine beobachtete Busspannung umfassen;

Berechnen (406b), durch das System über den einen oder die mehreren Hardwareprozessoren, einer Ableitung der geschätzten Busspannung basierend auf den Zeitperiodendetails unter Verwendung einer automatischen Differenzierungstechnik;

Berechnen (406c), durch das System über den einen oder die mehreren Hardwareprozessoren, einer Verlustfunktion für das neuronale Netzwerk basierend, zumindest teilweise, auf der Busspannung, der anfänglichen Busspannung, der beobachteten Busspannung und der Ableitung der geschätzten Busspannung unter Verwendung einer Verlustfunktionsberechnungstechnik;

Berechnen (406d), durch das System über den einen oder die mehreren Hardwareprozessoren, eines Gradienten der Verlustfunktion in Bezug auf den einen oder die mehreren initialisierten Modellparameter und die initialisierte Driftmatrix unter Verwendung einer Rückwärtsdurchgangstechnik;

Identifizieren (406e), durch das System über den einen oder die mehreren Hardwareprozessoren, eines optimalen Werts von jedem des einen oder der mehreren Modellparameter und der Driftmatrix, der die Verlustfunktion minimiert, unter Verwendung einer stochastischen Optimierungstechnik;

Bestimmen (406f), durch das System über den einen oder die mehreren Hardwareprozessoren, ob der optimale Wert der Driftmatrix ein vordefiniertes Driftmatrixkriterium erfüllt; und

nach dem Bestimmen, dass der optimale Wert der Driftmatrix das vordefinierte Driftmatrixkriterium nicht erfüllt, Aktualisieren (406g), durch das System über den einen oder die mehreren Hardwareprozessoren, des optimalen Werts der Driftmatrix als die initialisierte Driftmatrix und des optimalen Werts jedes Modellparameters als den initialisierten Modellparameter,

bis die initialisierte Driftmatrix das vordefinierte Driftmatrixkriterium erfüllt;

Identifizieren (408), durch das System über den einen oder die mehreren Hardwareprozessoren, der initialisierten Driftmatrix als eine optimale Driftmatrix und der Busspannung als eine endgültige Busspannung;

Schätzen (410), durch das System über den einen oder die mehreren Hardwareprozessoren, eines Leitungswiderstands und einer Leitungsreaktanz des Verteilungsnetzwerks basierend auf der optimalen Driftmatrix durch Lösen eines vordefinierten nichtlinearen Problems der Minimierung kleinster Fehlerquadrate; und

Schätzen (412), durch das System über den einen oder die mehreren Hardwareprozessoren, eines Leitungsstroms, eines Leitungswirkleistungsflusses und eines Leitungsblindleistungsflusses basierend, zumindest teilweise, auf dem geschätzten Leitungswiderstand, der geschätzten Leitungsreaktanz und der endgültigen Busspannung unter Verwendung einer oder mehrerer vordefinierter analytischer Leistungsflussgleichungen.

2. Prozessorimplementiertes Verfahren (400) nach Anspruch 1, umfassend:
Anzeigen, durch das System über den einen oder die mehreren Hardwareprozessoren, des Leitungswiderstands, der Leitungsreaktanz, des Leitungsstroms, der endgültigen Busspannung, des Leitungswirkleistungsflusses und des Leitungsblindleistungsflusses auf der Benutzervorrichtung.

3. Prozessorimplementiertes Verfahren (400) nach Anspruch 1, wobei die Verlustfunktion eine Kombination aus einem physischen Verlust, einem Anfangswertverlust und einem markierten Datenverlust ist.

4. Prozessorimplementiertes Verfahren (400) nach Anspruch 3, wobei der physische Verlust berechnet wird durch:

Berechnen, durch das System über den einen oder die mehreren Hardwareprozessoren, eines Rests basierend auf der Ableitung der geschätzten Busspannung unter Verwendung einer vordefinierten Restberechnungsgleichung; und

Berechnen, durch das System über den einen oder die mehreren Hardwareprozessoren, einer euklidischen Norm des Rests, um den physischen Verlust zu erhalten.

5. Prozessorimplementiertes Verfahren (400) nach Anspruch 4, wobei der Anfangswertverlust durch Berechnen der euklidischen Norm des Rests berechnet wird, die basierend auf der anfänglichen Busspannung berechnet wird, und wobei der markierte Datenverlust durch Berechnen der euklidischen Norm des Rests berechnet wird, die basierend auf der beobachteten Busspannung berechnet wird.

6. System (102), umfassend:

einen Speicher (202), der Anweisungen speichert;

eine oder mehrere Kommunikationsschnittstellen (206); und

einen oder mehrere Hardwareprozessoren (204), die mit dem Speicher (202) über die eine oder die mehreren Kommunikationsschnittstellen (206) gekoppelt sind, wobei der eine oder die mehreren Hardwareprozessoren (204) durch die Anweisungen konfiguriert sind zum:

Empfangen einer Mehrzahl von Eingaben, die mit einem Verteilungsnetzwerk assoziiert sind, und von Zeitperiodendetails von einer Benutzervorrichtung, wobei die Mehrzahl von Eingaben Echtzeit-Busleistungsinjektionsdaten und historische Spannungsdaten umfasst, wobei die Echtzeit-Busleistungsinjektionsdaten Wirkleistungsinjektionsdaten und Blindleistungsinjektionsdaten umfassen;

Initialisieren eines oder mehrerer Modellparameter eines neuronalen Netzwerks und einer Driftmatrix des Verteilungsnetzwerks, wobei der eine oder die mehreren Modellparameter und die Driftmatrix zufällig initialisiert werden;

iteratives Durchführen:

Schätzen einer oder mehrerer Busspannungen basierend, zumindest teilweise, auf der Mehrzahl von Eingaben, den Zeitperiodendetails, dem einen oder den mehreren initialisierten Modellparametern und der initialisierten Driftmatrix durch Anwenden einer Vorwärtsdurchgangstechnik auf das neuronale Netzwerk, wobei die eine oder die mehreren Busspannungen eine Busspannung, eine anfängliche Busspannung und eine beobachtete Busspannung umfassen;

Berechnen einer Ableitung der geschätzten Busspannung basierend auf den Zeitperiodendetails unter Verwendung einer automatischen Differenzierungstechnik;

Berechnen einer Verlustfunktion für das neuronale Netzwerk basierend, zumindest teilweise, auf der Busspannung, der anfänglichen Busspannung, der beobachteten Busspannung und der Ableitung der geschätzten Busspannung unter Verwendung einer Verlustfunktionsberechnungstechnik;

Berechnen eines Gradienten der Verlustfunktion in Bezug auf den einen oder die mehreren initialisierten Modellparameter und die initialisierte Driftmatrix unter Verwendung einer Rückwärtsdurchgangstechnik;

Identifizieren eines optimalen Werts von jedem des einen oder der mehreren Modellparameter und der Driftmatrix, der die Verlustfunktion minimiert, unter Verwendung einer stochastischen Optimierungstechnik;

Bestimmen, ob der optimale Wert der Driftmatrix ein vordefiniertes Driftmatrixkriterium erfüllt; und

nach dem Bestimmen, dass der optimale Wert der Driftmatrix das vordefinierte Driftmatrixkriterium nicht erfüllt, Aktualisieren des optimalen Werts der Driftmatrix als die initialisierte Driftmatrix und des optimalen Werts jedes Modellparameters als den initialisierten Modellparameter,

bis die initialisierte Driftmatrix das vordefinierte Driftmatrixkriterium erfüllt;

Identifizieren der initialisierten Driftmatrix als eine optimale Driftmatrix und der Busspannung als eine endgültige Busspannung;

Schätzen eines Leitungswiderstands und einer Leitungsreaktanz des Verteilungsnetzwerks basierend auf der optimalen Driftmatrix durch Lösen eines vordefinierten nichtlinearen Problems der Minimierung kleinster Fehlerquadrate; und

Schätzen eines Leitungsstroms, eines Leitungswirkleistungsflusses und eines Leitungsblindleistungsflusses basierend, zumindest teilweise, auf dem geschätzten Leitungswiderstand, der geschätzten Leitungsreaktanz und der endgültigen Busspannung unter Verwendung einer oder mehrerer vordefinierter analytischer Leistungsflussgleichungen.

7. System (102) nach Anspruch 6, wobei der eine oder die mehreren Hardwareprozessoren (204) durch die Anweisungen konfiguriert sind zum:

Anzeigen des Leitungswiderstands, der Leitungsreaktanz, des Leitungsstroms, der endgültigen Busspannung, des Leitungswirkleistungsflusses und des Leitungsblindleistungsflusses auf der Benutzervorrichtung.

8. System (102) nach Anspruch 6, wobei die Verlustfunktion eine Kombination aus einem physischen Verlust, einem Anfangswertverlust und einem markierten Datenverlust ist.

9. System (102) nach Anspruch 6, wobei der eine oder die mehreren Hardwareprozessoren (204) den physischen Verlust berechnen durch:

Berechnen eines Rests basierend auf der Ableitung der geschätzten Busspannung unter Verwendung einer vordefinierten Restberechnungsgleichung; und
Berechnen einer euklidischen Norm des Rests, um den physischen Verlust zu erhalten.

10. System (102) nach Anspruch 9, wobei der Anfangswertverlust durch Berechnen der euklidischen Norm des Rests berechnet wird, die basierend auf der anfänglichen Busspannung berechnet wird, und wobei der markierte Datenverlust durch Berechnen der euklidischen Norm des Rests berechnet wird, die basierend auf der beobachteten Busspannung berechnet wird.

11. Ein oder mehrere nichtflüchtige maschinenlesbare Informationsspeichermedien, umfassend eine oder mehrere Anweisungen, die bei Ausführung durch einen oder mehrere Hardwareprozessoren bewirken:

Empfangen einer Mehrzahl von Eingaben, die mit einem Verteilungsnetzwerk assoziiert sind, und von Zeitperiodendetails von einer Benutzervorrichtung, wobei die Mehrzahl von Eingaben Echtzeit-Busleistungsinjektionsdaten und historische Spannungsdaten umfasst, wobei die Echtzeit-Busleistungsinjektionsdaten Wirkleistungsinjektionsdaten und Blindleistungsinjektionsdaten umfassen;
Initialisieren eines oder mehrerer Modellparameter eines neuronalen Netzwerks und einer Driftmatrix des Verteilungsnetzwerks, wobei der eine oder die mehreren Modellparameter und die Driftmatrix zufällig initialisiert werden;
iteratives Durchführen:

Schätzen einer oder mehrerer Busspannungen basierend, zumindest teilweise, auf der Mehrzahl von Eingaben, den Zeitperiodendetails, dem einen oder den mehreren initialisierten Modellparametern und der initialisierten Driftmatrix durch Anwenden einer Vorwärtsdurchgangstechnik auf das neuronale Netzwerk, wobei die eine oder die mehreren Busspannungen eine Busspannung, eine anfängliche Busspannung und eine beobachtete Busspannung umfassen;
Berechnen einer Ableitung der geschätzten Busspannung basierend auf den Zeitperiodendetails unter Verwendung einer automatischen Differenzierungstechnik;
Berechnen einer Verlustfunktion für das neuronale Netzwerk basierend, zumindest teilweise, auf der Busspannung, der anfänglichen Busspannung, der beobachteten Busspannung und der Ableitung der geschätzten Busspannung unter Verwendung einer Verlustfunktionsberechnungstechnik;
Berechnen eines Gradienten der Verlustfunktion in Bezug auf den einen oder die mehreren initialisierten Modellparameter und die initialisierte Driftmatrix unter Verwendung einer Rückwärtsdurchgangstechnik;
Identifizieren eines optimalen Werts von jedem des einen oder der mehreren Modellparameter und der Driftmatrix, der die Verlustfunktion minimiert, unter Verwendung einer stochastischen Optimierungstechnik;
Bestimmen, ob der optimale Wert der Driftmatrix ein vordefiniertes Driftmatrixkriterium erfüllt; und
nach dem Bestimmen, dass der optimale Wert der Driftmatrix das vordefinierte Driftmatrixkriterium nicht erfüllt, Aktualisieren des optimalen Werts der Driftmatrix als die initialisierte Driftmatrix und des optimalen Werts jedes Modellparameters als den initialisierten Modellparameter,
bis die initialisierte Driftmatrix das vordefinierte Driftmatrixkriterium erfüllt;

Identifizieren der initialisierten Driftmatrix als eine optimale Driftmatrix und der Busspannung als eine endgültige Busspannung;
Schätzen eines Leitungswiderstands und einer Leitungsreaktanz des Verteilungsnetzwerks basierend auf der optimalen Driftmatrix durch Lösen eines vordefinierten nichtlinearen Problems der Minimierung kleinster Fehlerquadrate; und
Schätzen eines Leitungsstroms, eines Leitungswirkleistungsflusses und eines Leitungsblindleistungsflusses basierend, zumindest teilweise, auf dem geschätzten Leitungswiderstand, der geschätzten Leitungsreaktanz und der endgültigen Busspannung unter Verwendung einer oder mehrerer vordefinierter analytischer Leistungsflussgleichungen.

12. Ein oder mehrere nichtflüchtige maschinenlesbare Informationsspeichermedien nach Anspruch 11, umfassend:

Anzeigen des Leitungswiderstands, der Leitungsreaktanz, des Leitungsstroms, der endgültigen Busspannung, des Leitungswirkleistungsflusses und des Leitungsblindleistungsflusses auf der Benutzervorrichtung.

13. Ein oder mehrere nichtflüchtige maschinenlesbare Informationsspeichermedien nach Anspruch 11, wobei die Verlustfunktion eine Kombination aus einem physischen Verlust, einem Anfangswertverlust und einem markierten Datenverlust ist.

14. Ein oder mehrere nichtflüchtige maschinenlesbare Informationsspeichermedien nach Anspruch 13, wobei der physische Verlust berechnet wird durch:

Berechnen eines Rests basierend auf der Ableitung der geschätzten Busspannung unter Verwendung einer vordefinierten Restberechnungsgleichung; und
Berechnen einer euklidischen Norm des Rests, um den physischen Verlust zu erhalten.

15. Ein oder mehrere nichtflüchtige maschinenlesbare Informationsspeichermedien nach Anspruch 14, wobei der Anfangswertverlust durch Berechnen der euklidischen Norm des Rests berechnet wird, die basierend auf der anfänglichen Busspannung berechnet wird, und wobei der markierte Datenverlust durch Berechnen der euklidischen Norm des Rests berechnet wird, die basierend auf der beobachteten Busspannung berechnet wird.

**Revendications**

1. Procédé mis en œuvre par processeur (400), comprenant :

la réception (402), par un système par l'intermédiaire d'un ou plusieurs processeurs matériels, d'une pluralité d'entrées associées à un réseau de distribution et de détails de période de temps à partir d'un dispositif utilisateur, dans lequel la pluralité d'entrées comprend des données d'injection d'énergie de bus en temps réel et des données de tension historique, dans lequel les données d'injection d'énergie de bus en temps réel comprennent des données d'injection d'énergie active et des données d'injection d'énergie réactive ;
l'initialisation (404), par le système par l'intermédiaire des un ou plusieurs processeurs matériels, d'un ou plusieurs paramètres de modèle d'un réseau neuronal et d'une matrice de dérive du réseau de distribution, dans lequel les un ou plusieurs paramètres de modèle et la matrice de dérive sont initialisés de manière aléatoire ;
l'exécution itérative (406) :

de l'estimation (406a), par le système par l'intermédiaire des un ou plusieurs processeurs matériels, d'une ou plusieurs tensions de bus sur la base, au moins en partie, de la pluralité d'entrées, des détails de période de temps, des un ou plusieurs paramètres de modèle initialisés, et de la matrice de dérive initialisée en appliquant une technique de passage direct sur le réseau neuronal, dans lequel les une ou plusieurs tensions de bus comprennent une tension de bus, une tension de bus initiale et une tension de bus observée ;
du calcul (406b), par le système par l'intermédiaire des un ou plusieurs processeurs matériels, d'une dérivée de la tension de bus estimée sur la base des détails de période de temps en utilisant une technique de différentiation automatique ;
du calcul (406c), par le système par l'intermédiaire des un ou plusieurs processeurs matériels, d'une fonction de perte pour le réseau neuronal sur la base, au moins en partie, de la tension de bus, de la tension de bus initiale, de la tension de bus observée et de la dérivée de la tension de bus estimée en utilisant une technique de calcul de fonction de perte ;
du calcul (406d), par le système par l'intermédiaire des un ou plusieurs processeurs matériels, d'un gradient de la fonction de perte par rapport aux un ou plusieurs paramètres de modèle initialisés et à la matrice de dérive initialisée en utilisant une technique de rétropropagation ;
de l'identification (406e), par le système par l'intermédiaire des un ou plusieurs processeurs matériels, d'une valeur optimale de chacun des un ou plusieurs paramètres de modèle et de la matrice de dérive qui minimise la fonction de perte en utilisant une technique d'optimisation stochastique ;
de la détermination (406f), par le système par l'intermédiaire des un ou plusieurs processeurs matériels, si la valeur optimale de la matrice de dérive satisfait à un critère de matrice de dérive prédéfini ; et
lors de la détermination que la valeur optimale de la matrice de dérive ne satisfait pas au critère de matrice de dérive prédéfini, de la mise à jour (406g), par le système par l'intermédiaire des un ou plusieurs processeurs matériels, de la valeur optimale de la matrice de dérive en tant que matrice de dérive initialisée et de la valeur optimale de chaque paramètre de modèle en tant que paramètre de modèle initialisé,

jusqu'à ce que la matrice de dérive initialisée satisfasse au critère de matrice de dérive prédéfini ;

de l'identification (408), par le système par l'intermédiaire des un ou plusieurs processeurs matériels, de la matrice de dérive initialisée en tant que matrice de dérive optimale et de la tension de bus en tant que tension de bus finale ;

de l'estimation (410), par le système par l'intermédiaire des un ou plusieurs processeurs matériels, d'une résistance de ligne et d'une réactance de ligne du réseau de distribution sur la base de la matrice de dérive optimale en résolvant un problème de minimisation d'erreur des moindres carrés non linéaire prédéfini ; et

de l'estimation (412), par le système par l'intermédiaire des un ou plusieurs processeurs matériels, d'un courant de ligne, d'un flux d'énergie active de ligne et d'un flux d'énergie réactive de ligne sur la base, au moins en partie, de la résistance de ligne estimée, de la réactance de ligne estimée et de la tension de bus finale en utilisant une ou plusieurs équations de flux d'énergie analytiques prédéfinies.

2. Procédé mis en œuvre par processeur (400) selon la revendication 1, comprenant :
l'affichage, par le système par l'intermédiaire des un ou plusieurs processeurs matériels, de la résistance de ligne, de la réactance de ligne, du courant de ligne, de la tension de bus finale, du flux d'énergie active de ligne et du flux d'énergie réactive de ligne sur le dispositif utilisateur.

3. Procédé mis en œuvre par processeur (400) selon la revendication 1, dans lequel la fonction de perte est une combinaison d'une perte physique, d'une perte de valeur initiale et d'une perte de données étiquetées.

4. Procédé mis en œuvre par processeur (400) selon la revendication 3, dans lequel la perte physique est calculée par :

le calcul, par le système par l'intermédiaire des un ou plusieurs processeurs matériels, d'un résidu sur la base de la dérivée de la tension de bus estimée en utilisant une équation de calcul de résidu prédéfinie ; et
le calcul, par le système par l'intermédiaire des un ou plusieurs processeurs matériels, d'une norme euclidienne du résidu pour obtenir la perte physique.

5. Procédé mis en œuvre par processeur (400) selon la revendication 4, dans lequel la perte de valeur initiale est calculée en calculant la norme euclidienne du résidu sur la base de la tension de bus initiale, et dans lequel la perte de données étiquetées est calculée en calculant la norme euclidienne du résidu sur la base de la tension de bus observée.

6. Système (102), comprenant :

une mémoire (202) stockant des instructions ;
une ou plusieurs interfaces de communication (206) ; et
un ou plusieurs processeurs matériels (204) couplés à la mémoire (202) par l'intermédiaire des une ou plusieurs interfaces de communication (206), dans lequel les un ou plusieurs processeurs matériels (204) sont configurés par les instructions pour :

recevoir une pluralité d'entrées associées à un réseau de distribution et des détails de période de temps à partir d'un dispositif utilisateur, dans lequel la pluralité d'entrées comprend des données d'injection d'énergie de bus en temps réel et des données de tension historique, dans lequel les données d'injection d'énergie de bus en temps réel comprennent des données d'injection d'énergie active et des données d'injection d'énergie réactive ;
initialiser un ou plusieurs paramètres de modèle d'un réseau neuronal et une matrice de dérive du réseau de distribution, dans lequel les un ou plusieurs paramètres de modèle et la matrice de dérive sont initialisés de manière aléatoire ;
effectuer itérativement :

l'estimation d'une ou plusieurs tensions de bus sur la base, au moins en partie, de la pluralité d'entrées, des détails de période de temps, des un ou plusieurs paramètres de modèle initialisés, et de la matrice de dérive initialisée en appliquant une technique de passage direct sur le réseau neuronal, dans lequel les une ou plusieurs tensions de bus comprennent une tension de bus, une tension de bus initiale et une tension de bus observée ;
le calcul d'une dérivée de la tension de bus estimée sur la base des détails de période de temps en utilisant une technique de différentiation automatique ;

le calcul d'une fonction de perte pour le réseau neuronal sur la base, au moins en partie, de la tension de bus, de la tension de bus initiale, de la tension de bus observée et de la dérivée de la tension de bus estimée en utilisant une technique de calcul de fonction de perte ;

le calcul d'un gradient de la fonction de perte par rapport aux un ou plusieurs paramètres de modèle initialisés et à la matrice de dérive initialisée en utilisant une technique de rétropropagation ;

l'identification d'une valeur optimale de chacun des un ou plusieurs paramètres de modèle et de la matrice de dérive qui minimise la fonction de perte en utilisant une technique d'optimisation stochastique ;

la détermination si la valeur optimale de la matrice de dérive satisfait à un critère de matrice de dérive prédéfini ; et

lors de la détermination que la valeur optimale de la matrice de dérive ne satisfait pas au critère de matrice de dérive prédéfini, la mise à jour de la valeur optimale de la matrice de dérive en tant que matrice de dérive initialisée et de la valeur optimale de chaque paramètre de modèle en tant que paramètre de modèle initialisé,

jusqu'à ce que la matrice de dérive initialisée satisfasse au critère de matrice de dérive prédéfini ;

l'identification de la matrice de dérive initialisée en tant que matrice de dérive optimale et de la tension de bus en tant que tension de bus finale ;

l'estimation d'une résistance de ligne et d'une réactance de ligne du réseau de distribution sur la base de la matrice de dérive optimale en résolvant un problème de minimisation d'erreur des moindres carrés non linéaire prédéfini ; et

l'estimation d'un courant de ligne, d'un flux d'énergie active de ligne et d'un flux d'énergie réactive de ligne sur la base, au moins en partie, de la résistance de ligne estimée, de la réactance de ligne estimée et de la tension de bus finale en utilisant une ou plusieurs équations de flux d'énergie analytiques prédéfinies.

7. Système (102) selon la revendication 6, dans lequel les un ou plusieurs processeurs matériels (204) sont configurés par les instructions pour :
afficher la résistance de ligne, la réactance de ligne, le courant de ligne, la tension de bus finale, le flux d'énergie active de ligne et le flux d'énergie réactive de ligne sur le dispositif utilisateur.

8. Système (102) selon la revendication 6, dans lequel la fonction de perte est une combinaison d'une perte physique, d'une perte de valeur initiale et d'une perte de données étiquetées.

9. Système (102) selon la revendication 6, dans lequel les un ou plusieurs processeurs matériels (204) calculent la perte physique par :

le calcul d'un résidu sur la base de la dérivée de la tension de bus estimée en utilisant une équation de calcul de résidu prédéfinie ; et
le calcul d'une norme euclidienne du résidu pour obtenir la perte physique.

10. Système (102) selon la revendication 9, dans lequel la perte de valeur initiale est calculée en calculant la norme euclidienne du résidu sur la base de la tension de bus initiale, et dans lequel la perte de données étiquetées est calculée en calculant la norme euclidienne du résidu sur la base de la tension de bus observée.

11. Un ou plusieurs supports de stockage d'informations lisibles par machine non transitoires comprenant une ou plusieurs instructions qui, lorsqu'elles sont exécutées par un ou plusieurs processeurs matériels, amènent :

la réception, d'une pluralité d'entrées associées à un réseau de distribution et de détails de période de temps à partir d'un dispositif utilisateur, dans lequel la pluralité d'entrées comprend des données d'injection d'énergie de bus en temps réel et des données de tension historique, dans lequel les données d'injection d'énergie de bus en temps réel comprennent des données d'injection d'énergie active et des données d'injection d'énergie réactive ;
l'initialisation, d'un ou plusieurs paramètres de modèle d'un réseau neuronal et d'une matrice de dérive du réseau de distribution, dans lequel les un ou plusieurs paramètres de modèle et la matrice de dérive sont initialisés de manière aléatoire ;
l'exécution itérative :

de l'estimation, d'une ou plusieurs tensions de bus sur la base, au moins en partie, de la pluralité d'entrées, des détails de période de temps, des un ou plusieurs paramètres de modèle initialisés, et de la matrice de dérive initialisée en appliquant une technique de passage direct sur le réseau neuronal, dans lequel les une ou plusieurs tensions de bus comprennent une tension de bus, une tension de bus initiale et une tension de bus observée ;

du calcul, d'une dérivée de la tension de bus estimée sur la base des détails de période de temps en utilisant une technique de différentiation automatique ;

du calcul, d'une fonction de perte pour le réseau neuronal sur la base, au moins en partie, de la tension de bus, de la tension de bus initiale, de la tension de bus observée et de la dérivée de la tension de bus estimée en utilisant une technique de calcul de fonction de perte ;

du calcul, d'un gradient de la fonction de perte par rapport aux un ou plusieurs paramètres de modèle initialisés et à la matrice de dérive initialisée en utilisant une technique de rétropropagation ;

de l'identification, d'une valeur optimale de chacun des un ou plusieurs paramètres de modèle et de la matrice de dérive qui minimise la fonction de perte en utilisant une technique d'optimisation stochastique ;

de la détermination si la valeur optimale de la matrice de dérive satisfait à un critère de matrice de dérive prédéfini ; et

lors de la détermination que la valeur optimale de la matrice de dérive ne satisfait pas au critère de matrice de dérive prédéfini, de la mise à jour, de la valeur optimale de la matrice de dérive en tant que matrice de dérive initialisée et de la valeur optimale de chaque paramètre de modèle en tant que paramètre de modèle initialisé, jusqu'à ce que la matrice de dérive initialisée satisfasse au critère de matrice de dérive prédéfini ;

de l'identification, de la matrice de dérive initialisée en tant que matrice de dérive optimale et de la tension de bus en tant que tension de bus finale ;

de l'estimation, d'une résistance de ligne et d'une réactance de ligne du réseau de distribution sur la base de la matrice de dérive optimale en résolvant un problème de minimisation d'erreur des moindres carrés non linéaire prédéfini ; et

de l'estimation, d'un courant de ligne, d'un flux d'énergie active de ligne et d'un flux d'énergie réactive de ligne sur la base, au moins en partie, de la résistance de ligne estimée, de la réactance de ligne estimée et de la tension de bus finale en utilisant une ou plusieurs équations de flux d'énergie analytiques prédéfinies.

12. Un ou plusieurs supports de stockage d'informations lisibles par machine non transitoires selon la revendication 11, comprenant :

l'affichage, de la résistance de ligne, de la réactance de ligne, du courant de ligne, de la tension de bus finale, du flux d'énergie active de ligne et du flux d'énergie réactive de ligne sur le dispositif utilisateur.

13. Un ou plusieurs supports de stockage d'informations lisibles par machine non transitoires selon la revendication 11, dans lequel la fonction de perte est une combinaison d'une perte physique, d'une perte de valeur initiale et d'une perte de données étiquetées.

14. Un ou plusieurs supports de stockage d'informations lisibles par machine non transitoires selon la revendication 13, dans lequel la perte physique est calculée par :

le calcul, d'un résidu sur la base de la dérivée de la tension de bus estimée en utilisant une équation de calcul de résidu prédéfinie ; et

le calcul, d'une norme euclidienne du résidu pour obtenir la perte physique.

15. Un ou plusieurs supports de stockage d'informations lisibles par machine non transitoires selon la revendication 14, dans lequel la perte de valeur initiale est calculée en calculant la norme euclidienne du résidu sur la base de la tension de bus initiale, et dans lequel la perte de données étiquetées est calculée en calculant la norme euclidienne du résidu sur la base de la tension de bus observée.

**FIG. 1**

100

SYSTEM
102

MEMORY
202

DATABASE
208

HARDWARE
PROCESSOR(S)
204

INTERFACE(S)
206

**FIG. 2**

*Input Data*

- Historical bus voltage measurements
- Load and DER data
- Topology information

time

*i-PINN architecture*

- Estimate network drift matrix and bus voltages
- Forward pass-Use input data and estimate bus voltages
- Loss function includes ODE + initial value + labeled data residual
- Backward pass drift matrix is updated using the derivatives of the loss function to approximate the desired solution

*Bus voltage and drift matrix estimates*

*Line parameter predictor*

- Solve a non-linear least square error minimization problem
- Use design parameter info and domain knowledge

*Estimated line parameter values*

Analytically reconstruct the line power flows and the line currents estimates using the power flow equations

*Line flow reconstructor*

*Estimated line (re)active power flows and line currents*

Control Center

**FIG. 3**

receiving, by a system via one or more hardware processors, a plurality of inputs associated with a distribution network and a time period details from a user device, wherein the plurality of inputs comprises a real time bus power injection data and a historical voltage data, wherein the real time bus power injection data comprises an active power injection data and a reactive power injection data — 402

initializing, by the system via the one or more hardware processors, one or more model parameters of a neural network and a drift matrix of the distribution network, wherein the one or more model parameters and the drift matrix are initialized randomly — 404

iteratively performing:

estimating, by the system via the one or more hardware processors, one or more bus voltages based, at least in part, on the plurality of inputs, the time period details, the one or more initialized model parameters, and the initialized drift matrix by applying a forward pass technique on the neural network, wherein the one or more bus voltages comprises a bus voltage, an initial bus voltage and an observed bus voltage — 406a

computing, by the system via the one or more hardware processors, a derivative of the estimated bus voltage based on the time period details using an automatic differentiation technique — 406b

computing, by the system via the one or more hardware processors, a loss function for the neural network based, at least in part, on the bus voltage, the initial bus voltage, the observed bus voltage and the derivative of the estimated bus voltage using a loss function computation technique — 406c

A

400

**FIG. 4A**

A

computing, by the system via the one or more hardware processors, a gradient of the loss function with respect to the one or more initialized model parameters and the initialized drift matrix using a backward pass technique — 406d

identifying, by the system via the one or more hardware processors, an optimal value of each of the one or more model parameters and the drift matrix that minimizes the loss function using a stochastic optimization technique — 406e

determining, by the system via the one or more hardware processors, whether the optimal value of the drift matrix meets a predefined drift matrix criteria — 406f

upon determining that the optimal value of the drift matrix is not meeting the predefined drift matrix criteria, updating, by the system via the one or more hardware processors, the optimal value of the drift matrix as the initialized drift matrix and the optimal value of each model parameters as the initialized model parameter, until the initialized drift matrix meets the predefined drift matrix criteria — 406g

identifying, by the system via the one or more hardware processors, the initialized drift matrix as an optimal drift matrix and the bus voltage as a final bus voltage — 408

B

400

**FIG. 4B**

B

estimating, by the system via the one or more hardware processors, a line resistance and a line reactance of the distribution network based on the optimal drift matrix by solving a predefined non-linear least square error minimization problem — 410

estimating , by the system via the one or more hardware processors, a line current, a line active power flow and a line reactive power flow based, at least in part, on the estimated line resistance, the estimated line reactance and the final bus voltage using one or more predefined analytical power flow equations — 412

**FIG. 4C**

400

EP 4 586 436 B1

Neural network

$t$

$v^0$

$u^t$

$d^t$

$\sigma$ ⋯ $\sigma$

$\hat{v}_p$

Forward pass

Physics-informed

$\dfrac{\partial}{\partial t}$

Backward pass

$\min\limits_{\theta,\hat{\mathcal{F}}} \mathcal{L}\left(\theta,\hat{\mathcal{F}}\right)$

$$\mathcal{L}\left(\theta,\hat{\mathcal{F}}\right) = \underbrace{\frac{1}{N_p}\sum_{N_p}\left\|\frac{\partial \hat{v}_p}{\partial t} - \left(\hat{\mathcal{F}}\cdot u^t + d^t\right)\right\|^2}_{\text{ODE Residual}} + \underbrace{\frac{1}{N_0}\sum_{N_0}\|\hat{v}_0 - v_0\|^2}_{\text{Initial value loss}} + \underbrace{\frac{1}{N_d}\sum_{N_d}\|\hat{v}_d - v_d\|^2}_{\text{Labeled data loss}}$$

FIG. 5

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- IN 202421001995
- US 2012078436 A